# EUROPEAN PATENT APPLICATION

(11) **EP 4 794 506 A1**
(43) Date of publication of application: **19.08.2026**
(21) Application number: 25208887.7
(22) Date of filing: 15.10.2025
(51) Int. Cl.: H10P 58/00, H10P 54/92

(54) **SEMICONDUCTOR DEVICE**

(30) Priority: 13.02.2025 KR 20250018520
(71) Applicant: SK hynix Inc., Bubal-eub Icheon-si Gyeonggi-do 17336 (KR)
(72) Inventor: CHANG, Heon Yong, 17336 Icheon-si, Gyeonggi-do (KR); PARK, Sun Joo, 17336 Icheon-si, Gyeonggi-do (KR); BAEK, Jong Won, 17336 Icheon-si, Gyeonggi-do (KR); CHOI, Sang Deuk, 17336 Icheon-si, Gyeonggi-do (KR)
(74) Representative: Isarpatent

(57) **Abstract**

A semiconductor device includes a substrate including a chip region and a scribe lane region including a chip adjacent region, a chip adjacent crossing region, and a peripheral crossing region; a passivation layer; row trenches disposed between the boundary between the chip adjacent crossing region and a first boundary of the peripheral crossing region and the boundary between the chip adjacent crossing region and the chip adjacent region, in a direction crossing the first boundary, and disposed in the passivation layer; and column trenches disposed between the boundary between the chip adjacent crossing region and a second boundary of the peripheral crossing region and the boundary between the chip adjacent crossing region and the chip adjacent region, in a direction crossing the second boundary, and disposed in the passivation layer.

## Description

### BACKGROUND

### 1. Technical Field

Embodiments of the present disclosure relate to a semiconductor device.

### 2. Related Art

Semiconductor chips are attracting attention as an important element in the electronics industry due to their characteristics such as miniaturization, multi-functionality and/or low manufacturing cost. As the electronics industry advances, semiconductor chips are gradually becoming highly integrated. With this high degree of integration, the size of the chips is gradually decreasing, and the number of semiconductor chips formed on a single wafer is increasing.

Semiconductor chips are generally manufactured on a single wafer and then are divided into individual semiconductor chips through a cutting process such as sawing or dicing. As semiconductor chips become more highly integrated, the difficulty of the process of cutting semiconductor chips increases.

### SUMMARY

Embodiments of the present disclosure are directed to providing a semiconductor device in which a cutting defect occurring during a cutting process may be minimized.

Objects of embodiments of the disclosure are not limited to those set forth herein, and other unmentioned objects would be apparent to one of ordinary skill in the art from the following description.

In an embodiment, a semiconductor device may include: a substrate including a chip region and a scribe lane region, the scribe lane region including a chip adjacent region, a chip adjacent crossing region that abuts the chip adjacent region and a peripheral crossing region that abuts the chip adjacent crossing region and is spaced apart from the chip adjacent region; a passivation layer on the substrate; row trenches disposed between the boundary between the chip adjacent crossing region and a first boundary of the peripheral crossing region and the boundary between the chip adjacent crossing region and the chip adjacent region, in a direction that crosses the first boundary, and disposed in the passivation layer; and column trenches disposed between the boundary between the chip adjacent crossing region and a second boundary crossing the first boundary among the boundaries of the peripheral crossing region and the boundary between the chip adjacent crossing region and the chip adjacent region, in a direction that crosses the second boundary, and disposed in the passivation layer.

In an embodiment, a semiconductor device may include: a substrate including a chip region and a scribe lane region, the scribe lane region including a chip adjacent region, a chip adjacent crossing region that abuts the chip adjacent region and a peripheral crossing region that abuts the chip adjacent crossing region and is spaced apart from the chip adjacent region; row trenches disposed in the chip adjacent crossing region in a direction that crosses a first boundary of the peripheral crossing region, and located in a region other than the peripheral crossing region; and column trenches disposed in the chip adjacent crossing region in a direction that crosses a second boundary of the peripheral crossing region crossing the first boundary, and located in a region other than the peripheral crossing region, wherein each of the row trenches and each of the column trenches do not cross each other.

In an embodiment, a semiconductor device may include: a substrate including a chip region and a scribe lane region, the scribe lane region including a chip adjacent region, a chip adjacent crossing region that abuts the chip adjacent region, and a peripheral crossing region that abuts the chip adjacent crossing region and is spaced apart from the chip adjacent region, a passivation layer on the substrate, row trenches disposed in the passivation layer outside of the peripheral crossing region between a first boundary that marks an outer edge of the peripheral crossing region and a second boundary that marks an outer edge of the chip adjacent region, wherein at least one of the row trenches is disposed in the chip adjacent crossing region; and column trenches disposed in the passivation layer outside of the peripheral crossing region between a third boundary, perpendicular to the first boundary, that marks the peripheral crossing region and a fourth boundary, perpendicular to the second boundary, that marks the chip adjacent region, wherein at least one of the column trenches is disposed in the chip adjacent crossing region.

According to the embodiments of the present disclosure, a semiconductor device in which a cutting defect occurring during a cutting process may be minimized may be provided.

The effects of the disclosure are not limited to the foregoing objects, and other effects will be apparent to one of ordinary skill in the art from the following detailed description.

### BRIEF DESCRIPTION OF THE DRAWINGS

The disclosure will be more fully understood from the following detailed description and the accompanying drawings, which are provided for illustration only and are not intended to limit the disclosure.
FIG. 1 is a view illustrating a planar structure of a semiconductor device according to embodiments of the present disclosure.
FIG. 2 is a view illustrating a cross-sectional structure of a part indicated by a line I-I' of FIG. 1 according to an embodiment of the present disclosure.
FIG. 3 is a view illustrating a cross-sectional structure of a part indicated by a line II-II' of FIG. 1 according to an embodiment of the present disclosure.
FIG. 4 to FIG. 6 are views illustrating other examples of the cross-sectional structure of the part indicated by the line I-I' of FIG. 1 according to an embodiment of the present disclosure.
FIG. 7 is a view illustrating a planar structure of a semiconductor device according to embodiments of the present disclosure.
FIG. 8 is a view illustrating a cross-sectional structure of a part indicated by a line III-III' of FIG. 7 according to an embodiment of the present disclosure.
FIG. 9 is a view illustrating a planar structure of a semiconductor device according to embodiments of the present disclosure.
FIG. 10 is a view illustrating a cross-sectional structure of a part indicated by a line IV-IV' of FIG. 9 according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," "under," or "beneath" another element, the elements may directly contact each other or an intervening element may be disposed between the elements.

Terms such as "vertical," "horizontal," "top," "bottom," "above," "below," "under," "beneath," "over," "on," "side," "upper," "uppermost," "lower," "lowermost," "front," "rear," "left," "right," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

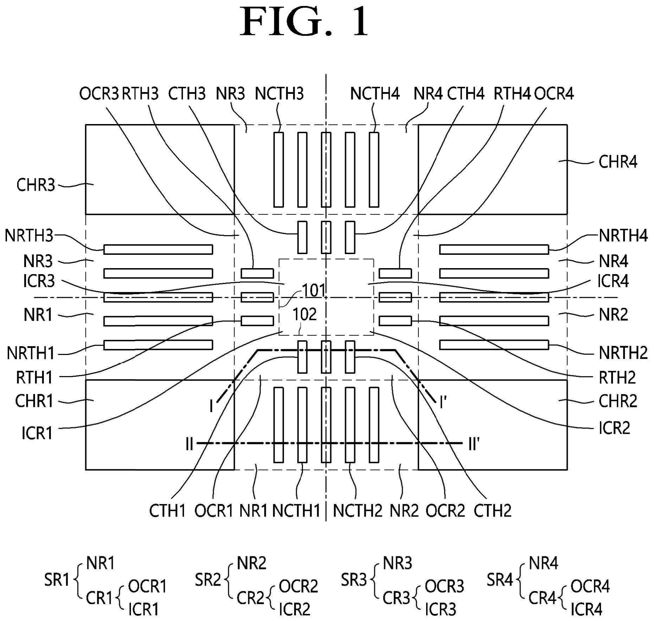

FIG. 1 is a view illustrating a planar structure of a semiconductor device according to embodiments of the present disclosure.

Referring to FIG. 1, a first chip region CHR1, a second chip region CHR2, a third chip region CHR3 and a fourth chip region CHR4 are disposed to be spaced apart from each other. The first chip region CHR1, the second chip region CHR2, the third chip region CHR3 and the fourth chip region CHR4 may correspond to regions that are included in different semiconductor devices, respectively. For example, the (particular) semiconductor device according to ensuing embodiments of the present disclosure may include the first chip region CHR1. FIG. 1 may be a view illustrating semiconductor devices before being separated into individual chips after being formed on a single wafer.

A first scribe lane region SR1 is disposed around the first chip region CHR1. The first scribe lane region SR1 may surround the first chip region CHR1. Similarly, a second scribe lane region SR2, a third scribe lane region SR3 and a fourth scribe lane region SR4 are disposed around the second chip region CHR2, the third chip region CHR3 and the fourth chip region CHR4, respectively, and may surround the second chip region CHR2, the third chip region CHR3 and the fourth chip region CHR4, respectively. The first scribe lane region SR1, the second scribe lane region SR2, the third scribe lane region SR3 and the fourth scribe lane region SR4 may be regions that result as one scribe lane region is separated by a cutting process (e.g., dicing or sawing) for separating semiconductor chips.

The first chip region CHR1 and the first scribe lane region SR1 may be regions that are included in one semiconductor device. For example, the semiconductor device according to the embodiments of the present disclosure may include the first chip region CHR1 and the first scribe lane region SR1. Only parts of the first chip region CHR1 and the first scribe lane region SR1 are illustrated in FIG. 1. Similarly, the second chip region CHR2 and the second scribe lane region SR2, the third chip region CHR3 and the third scribe lane region SR3, and the fourth chip region CHR4 and the fourth scribe lane region SR4 may be regions that are included in different semiconductor devices.

The first scribe lane region SR1 includes a first chip adjacent region NR1 and a first crossing region CR1. The first chip adjacent region NR1 may mean a region that is adjacent to the edge of the first chip region CHR1. The first crossing region CR1 may denote a region that is located at the periphery of the first chip adjacent region NR1 and abuts the first chip adjacent region NR1.

Similarly, the second scribe lane region SR2, the third scribe lane region SR3 and the fourth scribe lane region SR4 include a second chip adjacent region NR2 and a second crossing region CR2, a third chip adjacent region NR3 and a third crossing region CR3, and a fourth chip adjacent region NR4 and a fourth crossing region CR4, respectively.

The first crossing region CR1 includes a first chip adjacent crossing region OCR1 and a first peripheral crossing region ICR1. The first chip adjacent crossing region OCR1 may denote a region that abuts the first chip adjacent region NR1 outside the first chip adjacent region NR1. The first chip adjacent crossing region OCR1 might not overlap the first chip region CHR1. For example, the first chip adjacent crossing region OCR1 may share a single point with the first chip region CHR1 as in diagonally disposed squares (or rectangles) that do not overlap (i.e., at that point the first chip adjacent crossing region OCR1 and the first chip region CHR1 share a vertex).

The first peripheral crossing region ICR1 may denote a region that abuts the first chip adjacent crossing region OCR1 and is spaced apart from the first chip adjacent region NR1. In an embodiment, the first peripheral crossing region ICR1 may be a region that includes the crossing point of the boundary line between the first chip adjacent region NR1 and the third chip adjacent region NR3 and the boundary line between the first chip adjacent region NR1 and the second chip adjacent region NR2. In an embodiment, the first peripheral crossing region ICR1 may be a region that includes the crossing point of cutting lines for separating semiconductor chips formed on the wafer. For example, a point where a cutting line that separates a semiconductor device including the first chip region CHR1 and a semiconductor device including the third chip region CHR3 and a cutting line that separates the semiconductor device including the first chip region CHR1 and a semiconductor device including the second chip region CHR2 cross each other may be included in the first peripheral crossing region ICR1.

Similarly, the second crossing region CR2, the third crossing region CR3, and the fourth crossing region CR4 include a second chip adjacent crossing region OCR2 and a second peripheral crossing region ICR2, a third chip adjacent crossing region OCR3 and a third peripheral crossing region ICR3, and a fourth chip adjacent crossing region OCR4 and a fourth peripheral crossing region ICR4, respectively.

In the first scribe lane region SR1, first column trenches CTH1, first row trenches RTH1, first chip adjacent column trenches NCTH1 and first chip adjacent row trenches NRTH1 are disposed. In the second scribe lane region SR2, second column trenches CTH2, second row trenches RTH2, second chip adjacent column trenches NCTH2 and second chip adjacent row trenches NRTH2 are disposed. In the third scribe lane region SR3, third column trenches CTH3, third row trenches RTH3, third chip adjacent column trenches NCTH3 and third chip adjacent row trenches NRTH3 are disposed. In the fourth scribe lane region SR4, fourth column trenches CTH4, fourth row trenches RTH4, fourth chip adjacent column trenches NCTH4 and fourth chip adjacent row trenches NRTH4 are disposed. Hereinafter, the first column trenches CTH1, the second column trenches CTH2, the third column trenches CTH3, and the fourth column trenches CTH4 may also be referred to as the chip adjacent crossing trenches.

The first column trenches CTH1 may be substantially the same (for example, shape, depth, relative disposition, and orientation with respect to corresponding features) as the second column trenches CTH2 to the fourth column trenches CTH4. The first row trenches RTH1 may be substantially the same as the second row trenches RTH2 to the fourth row trenches RTH4. The first chip adjacent column trenches NCTH1 may be substantially the same as the second chip adjacent column trenches NCTH2 to the fourth chip adjacent column trenches NCTH4. The first chip adjacent row trenches NRTH1 may be substantially the same as the second chip adjacent row trenches NRTH2 to the fourth chip adjacent row trenches NRTH4. Hereinafter, for the convenience, components included in the first scribe lane region SR1 will be mainly described.

In the first chip adjacent region NR1, one or more first chip adjacent column trenches NCTH1 and one or more first chip adjacent row trenches NRTH1 may be disposed. The first chip adjacent column trenches NCTH1 may be disposed in the first chip adjacent region NR1 between the first chip region CHR1 and the second chip region CHR2. The first chip adjacent column trenches NCTH1 may be disposed in a direction that crosses a second boundary 102. The first chip adjacent column trenches NCTH1 may be spaced apart from each other in a direction that crosses a first boundary 101. In the present specification, the direction that crosses the first boundary 101 may be referred to as a row direction. The direction that crosses the second boundary 102 may be referred to as a column direction. The first boundary 101 and the second boundary 102 may mean two boundaries that cross each other among the boundaries of the first chip adjacent crossing region OCR1 and the first peripheral crossing region ICR1.

The first chip adjacent row trenches NRTH1 may be disposed in the first chip adjacent region NR1 between the first chip region CHR1 and the third chip region CHR3. The first chip adjacent row trenches NRTH1 may be disposed in the row direction. The first chip adjacent row trenches NRTH1 may be spaced apart from each other in the column direction. The numbers of first chip adjacent row trenches NRTH1 and first chip adjacent column trenches NCTH1 are not limited to the numbers as illustrated in FIG. 1.

In the first chip adjacent crossing region OCR1, one or more first column trenches CTH1 and one or more first row trenches RTH1 may be disposed. In an embodiment, the first column trenches CTH1 and the first row trenches RTH1 may be disposed in the first chip adjacent crossing region OCR1 and might not be disposed in the first peripheral crossing region ICR1. That is to say, the first column trenches CTH1 may be located in a region other than the first peripheral crossing region ICR1. Similarly, the first row trenches RTH1 may be located in a region other than the first peripheral crossing region ICR1.

The first column trenches CTH1 may be disposed in the column direction. The first column trenches CTH1 may be spaced apart from each other in the row direction. The first row trenches RTH1 may be disposed in the row direction. The first row trenches RTH1 may be spaced apart from each other in the column direction. The numbers of first row trenches RTH1 and first column trenches CTH1 are not limited to the numbers as illustrated in FIG. 1.

The first row trenches RTH1 may be located between the boundary between the first chip adjacent crossing region OCR1 and the first chip adjacent region NR1 and the boundary between the first chip adjacent crossing region OCR1 and the first boundary 101 of the first peripheral crossing region ICR1. In an embodiment, the first row trenches RTH1 may be located closer to the first chip adjacent region NR1 in the row direction than the first boundary 101.

The first column trenches CTH1 may be located between the boundary between the first chip adjacent crossing region OCR1 and the first chip adjacent region NR1, and the boundary between the first chip adjacent crossing region OCR1 and the second boundary 102 of the first peripheral crossing region ICR1. In an embodiment, the first column trenches CTH1 may be located closer to the first chip adjacent region NR1 in the column direction than the second boundary 102.

In an embodiment, each of the first row trenches RTH1 and each of the first column trenches CTH1 might not cross each other. In an embodiment, each of the first row trenches RTH1 and each of the first column trenches CTH1 might not overlap each other.

In an embodiment, each of the first row trenches RTH1 may be spaced apart from the first chip adjacent row trenches NRTH1. Each of the first column trenches CTH1 may be spaced apart from the first chip adjacent column trenches NCTH1.

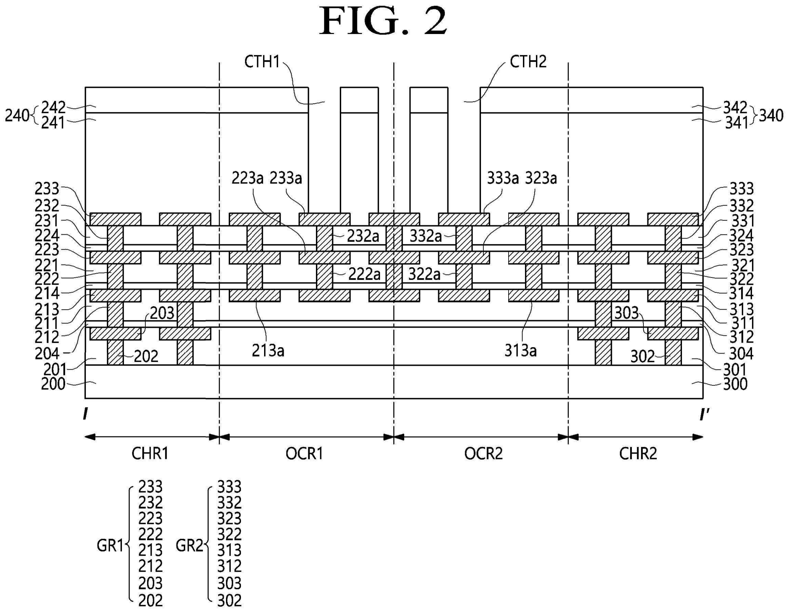

FIG. 2 is a view illustrating a cross-sectional structure of a part indicated by a line I-I' of FIG. 1. FIG. 2 may be a view illustrating semiconductor devices before being separated into individual chips after being formed on the single wafer. Semiconductor devices illustrated in FIG. 2 may be distinguished on the basis of the boundary between the first chip adjacent crossing region OCR1 and the second chip adjacent crossing region OCR2. Hereinbelow, among semiconductor devices, a semiconductor device that includes the first chip region CHR1 will be referred to as a first semiconductor device, and a semiconductor device that includes the second chip region CHR2 will be referred to as a second semiconductor device.

Referring to FIG. 2, the first semiconductor device may include a first substrate 200, a first insulating layer 201, a first guard ring GR1, a first interlayer insulating layer 204, a second insulating layer 211, a second interlayer insulating layer 214, a third insulating layer 221, a third interlayer insulating layer 224, a fourth insulating layer 231, a first passivation layer 240, a first dummy pattern 213a, a first dummy contact 222a, a second dummy pattern 223a, a second dummy contact 232a, a third dummy pattern 233a, and the first column trench CTH1. The first guard ring GR1 may include a first contact 202, a first wiring 203, a second contact 212, a second wiring 213, a third contact 222, a third wiring 223, a fourth contact 232, and a fourth wiring 233. The first passivation layer 240 may include a first lower passivation layer 241 and a first upper passivation layer 242.

Referring to FIG. 1 and FIG. 2, the first substrate 200 may include the first chip region CHR1 and the first scribe lane region SR1. For example, as illustrated in FIG. 2, the first substrate 200 may include the first chip region CHR1 and the first chip adjacent crossing region OCR1 of the first scribe lane region SR1. The first substrate 200 may include a semiconductor substrate such as a silicon wafer or a silicon-on-insulator (SOI) wafer. The first substrate 200 may include a III-V group semiconductor substrate, for example, a compound semiconductor substrate such as gallium arsenide (GaAs). The first substrate 200 may include monocrystalline silicon, polysilicon, amorphous silicon, monocrystalline silicon germanium, polycrystalline silicon germanium, carbon-doped silicon, or a combination thereof.

The first insulating layer 201 and the first contact 202 and the first wiring 203 of the first guard ring GR1 are disposed on the first substrate 200. The first guard ring GR1 may be disposed in the first chip region CHR1. The first insulating layer 201 may include silicon oxide, silicon nitride, silicon oxynitride, low-k dielectric, high-k dielectric, or a combination thereof. In an embodiment, the first insulating layer 201 may include oxide such as tetraethyl orthosilicate (TEOS). The first contact 202 and the first wiring 203 may include a conductive material such as metal, metal oxide, metal nitride, metal silicide, polysilicon, conductive carbon or a combination thereof. The first contact 202 and the first wiring 203 may include tungsten (W), tungsten nitride (WN), titanium (Ti), titanium nitride (TiN), aluminum (Al), copper (Cu), tantalum (Ta), tantalum nitride (TaN), gold (Au), or a combination thereof.

The first interlayer insulating layer 204 is disposed on the first wiring 203. The first interlayer insulating layer 204 may include silicon oxide, silicon nitride, silicon oxynitride, low-k dielectric, high-k dielectric, or a combination thereof. In an embodiment, the first interlayer insulating layer 204 may include silicon nitride.

The second insulating layer 211 is disposed on the first interlayer insulating layer 204. The second contact 212 and the second wiring 213 of the first guard ring GR1 are disposed in the second insulating layer 211. The second contact 212 may be connected to the first wiring 203 by penetrating the second insulating layer 211 and the first interlayer insulating layer 204. The second insulating layer 211, the second contact 212 and the second wiring 213 may include the same material as the first insulating layer 201, the first contact 202 and the first wiring 203, respectively.

In the first chip adjacent crossing region OCR1, the first dummy pattern 213a is disposed in the second insulating layer 211. The first dummy pattern 213a may include the same material as the second wiring 213. The second interlayer insulating layer 214 is disposed on the first dummy pattern 213a, the second wiring 213 and the second insulating layer 211. The second interlayer insulating layer 214 may include the same material as the first interlayer insulating layer 204.

The third insulating layer 221 is disposed on the second interlayer insulating layer 214. The third contact 222 and the third wiring 223 of the first guard ring GR1 are disposed in the third insulating layer 221. The third contact 222 may be connected to the second wiring 213 by penetrating the third insulating layer 221 and the second interlayer insulating layer 214. The third insulating layer 221, the third contact 222 and the third wiring 223 may include the same material as the first insulating layer 201, the first contact 202, and the first wiring 203, respectively.

In the first chip adjacent crossing region OCR1, the first dummy contact 222a and the second dummy pattern 223a are disposed in the third insulating layer 221. The first dummy contact 222a may be connected to the first dummy pattern 213a, and the second dummy pattern 223a may be connected to the first dummy contact 222a. The first dummy contact 222a may include the same material as the third contact 222, and the second dummy pattern 223a may include the same material as the third wiring 223. The third interlayer insulating layer 224 is disposed on the second dummy pattern 223a, the third wiring 223 and the third insulating layer 221. The third interlayer insulating layer 224 may include the same material as the first interlayer insulating layer 204.

The fourth insulating layer 231 is disposed on the third interlayer insulating layer 224. The fourth contact 232 of the first guard ring GR1 is disposed in the fourth insulating layer 231. The fourth contact 232 may be connected to the third wiring 223 by penetrating the fourth insulating layer 231 and the third interlayer insulating layer 224. The fourth insulating layer 231 and the fourth contact 232 may include the same material as the first insulating layer 201 and the first contact 202, respectively.

In the first chip adjacent crossing region OCR1, the second dummy contact 232a is disposed in the fourth insulating layer 231. The second dummy contact 232a may be connected to the second dummy pattern 223a. The second dummy contact 232a may include the same material as the fourth contact 232.

The third dummy pattern 233a is disposed on the second dummy contact 232a and the fourth insulating layer 231. The third dummy pattern 233a may be connected to the second dummy contact 232a. The third dummy pattern 233a may include the same material as the fourth wiring 233.

The first lower passivation layer 241 is disposed on the third dummy pattern 233a, the fourth wiring 233, and the fourth insulating layer 231. The first lower passivation layer 241 may cover the upper surfaces and the side surfaces of the fourth wiring 233 and the third dummy pattern 233a. The first lower passivation layer 241 may include silicon oxide, silicon nitride, silicon oxynitride, low-k dielectric, high-k dielectric, or a combination thereof. In an embodiment, the first lower passivation layer 241 may include high density plasma (HDP) oxide.

The first upper passivation layer 242 is disposed on the first lower passivation layer 241. In an embodiment, the first upper passivation layer 242 may include silicon nitride.

The first column trench CTH1 may be located in the first chip adjacent crossing region OCR1. The first column trench CTH1 may be disposed in the first passivation layer 240. In an embodiment, the first column trench CTH1 may overlap the third dummy pattern 233a. In an embodiment, the upper surface of the third dummy pattern 233a may be exposed by the first column trench CTH1. In an embodiment, the side surface of the first passivation layer 240 may be exposed by the first column trench CTH1.

Although the first column trench CTH1 is described with reference to FIG. 2 as an example, the above content may also be applied the same to the first row trench RTH1 described above with reference to FIG. 1. For example, the first row trench RTH1 may be located in the first chip adjacent crossing region OCR1. The first row trench RTH1 may be disposed in the first passivation layer 240 of FIG. 2. The first dummy pattern 213a, the second dummy pattern 223a and the third dummy pattern 233a of FIG. 2 may also be disposed under the first row trench RTH1. In an embodiment, the first row trench RTH1 may overlap the first dummy pattern 213a, the second dummy pattern 223a and the third dummy pattern 233a. In an embodiment, the upper surface of the third dummy pattern 233a may be exposed by the first row trench RTH1.

The second semiconductor device may include a second substrate 300, a fifth insulating layer 301, a second guard ring GR2, a fourth interlayer insulating layer 304, a sixth insulating layer 311, a fifth interlayer insulating layer 314, a seventh insulating layer 321, a sixth interlayer insulating layer 324, an eighth insulating layer 331, a second passivation layer 340, a fourth dummy pattern 313a, a fourth dummy contact 322a, a fifth dummy pattern 323a, a fifth dummy contact 332a, a sixth dummy pattern 333a, and the second column trench CTH2. The second guard ring GR2 may include a fifth contact 302, a fifth wiring 303, a sixth contact 312, a sixth wiring 313, a seventh contact 322, a seventh wiring 323, an eighth contact 332, and an eighth wiring 333. The second passivation layer 340 may include a second lower passivation layer 341 and a second upper passivation layer 342. The components included in the second semiconductor device may be substantially the same as the components, respectively, of the first semiconductor device described above with reference to FIG. 1 and FIG. 2.

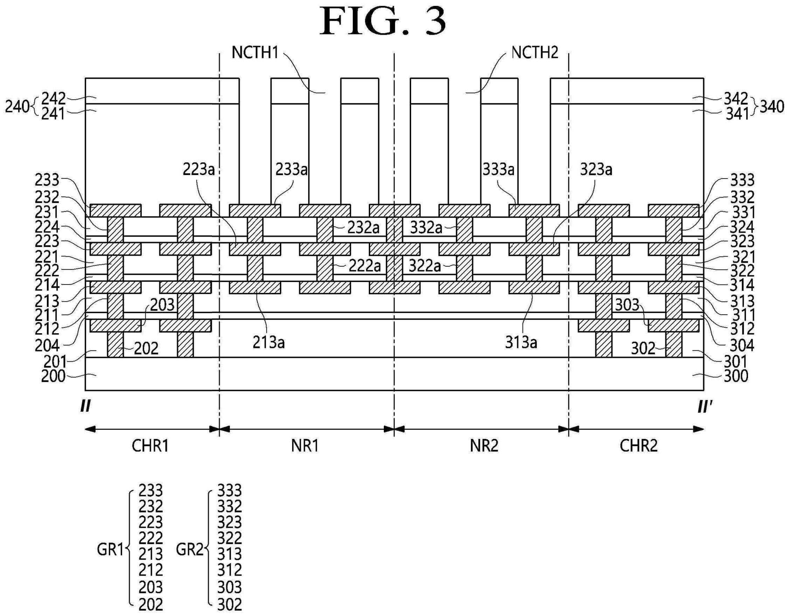

FIG. 3 is a view illustrating a cross-sectional structure of a part indicated by a line II-II' of FIG. 1.

Referring to FIG. 3, the first dummy pattern 213a, the first dummy contact 222a, the second dummy pattern 223a, the second dummy contact 232a, and the third dummy pattern 233a may be disposed in the first chip adjacent region NR1. In an embodiment, the first dummy pattern 213a, the first dummy contact 222a, the second dummy pattern 223a, the second dummy contact 232a, and the third dummy pattern 233a may extend from the first chip adjacent crossing region OCR1 to the first chip adjacent region NR1.

The first semiconductor device may include the first chip adjacent column trench NCTH1. The first chip adjacent column trench NCTH1 is located in the first chip adjacent region NR1. The first chip adjacent column trench NCTH1 may be disposed in the first passivation layer 240. In an embodiment, the first chip adjacent column trench NCTH1 may overlap the first dummy pattern 213a, the second dummy pattern 223a, and the third dummy pattern 233a.

Although the first chip adjacent column trench NCTH1 is described with reference to FIG. 3 as an example, the above content may also be applied the same to the first chip adjacent row trench NRTH1 described above with reference to FIG. 1. For example, the first chip adjacent row trench NRTH1 may be located within the first chip adjacent region NR1. The first chip adjacent row trench NRTH1 may be disposed in the first passivation layer 240 of FIG. 3. The first dummy pattern 213a, the second dummy pattern 223a and the third dummy pattern 233a of FIG. 3 may also be disposed under the first chip adjacent row trench NRTH1. In an embodiment, the first chip adjacent row trench NRTH1 may overlap the first dummy pattern 213a, the second dummy pattern 223a and the third dummy pattern 233a.

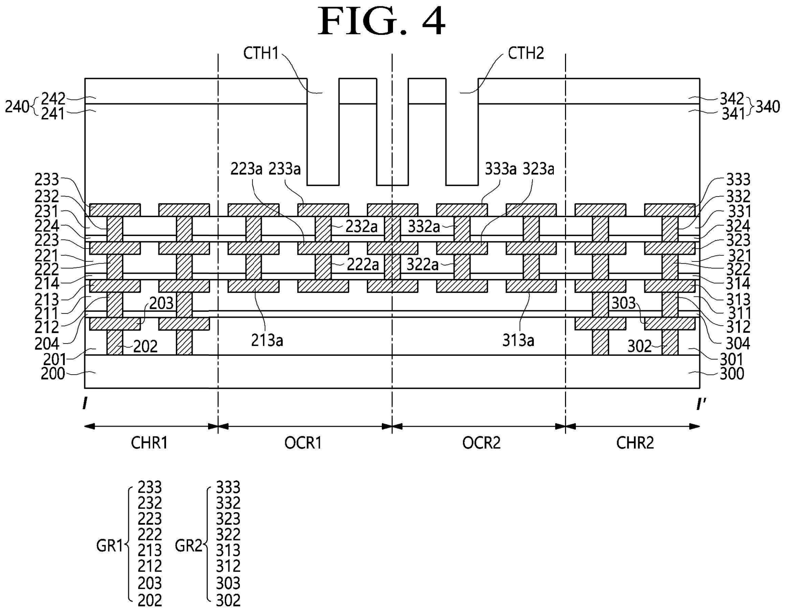

FIG. 4 to FIG. 6 are views illustrating other examples of the cross-sectional structure of the part indicated by the line I-I' of FIG. 1.

Referring to FIG. 4, the first column trench CTH1 may be located in the first chip adjacent crossing region OCR1. The first column trench CTH1 may be disposed in the first passivation layer 240. In an embodiment, the first column trench CTH1 might not expose the upper surface of the third dummy pattern 233a. The bottom surface of the first column trench CTH1 may be spaced apart from the upper surface of the third dummy pattern 233a. For example, at least a part of the first lower passivation layer 241 may remain between the bottom surface of the first column trench CTH1 and the upper surface of the third dummy pattern 233a.

The above content may be applied the same to the first row trench RTH1 described above with reference to FIG. 1. For example, the bottom surface of the first row trench RTH1 may be spaced apart from the upper surface of the third dummy pattern 233a.

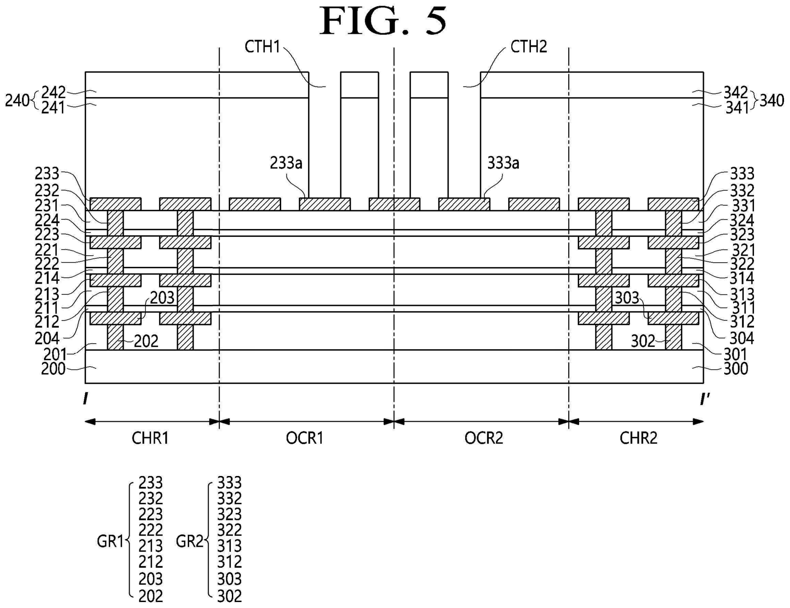

Referring to FIG. 5, the third dummy pattern 233a may be disposed on the fourth insulating layer 231. The third dummy pattern 233a may be disposed in the first chip adjacent crossing region OCR1. The first column trench CTH1 may overlap the third dummy pattern 233a. In an embodiment, the upper surface of the third dummy pattern 233a may be exposed by the first column trench CTH1.

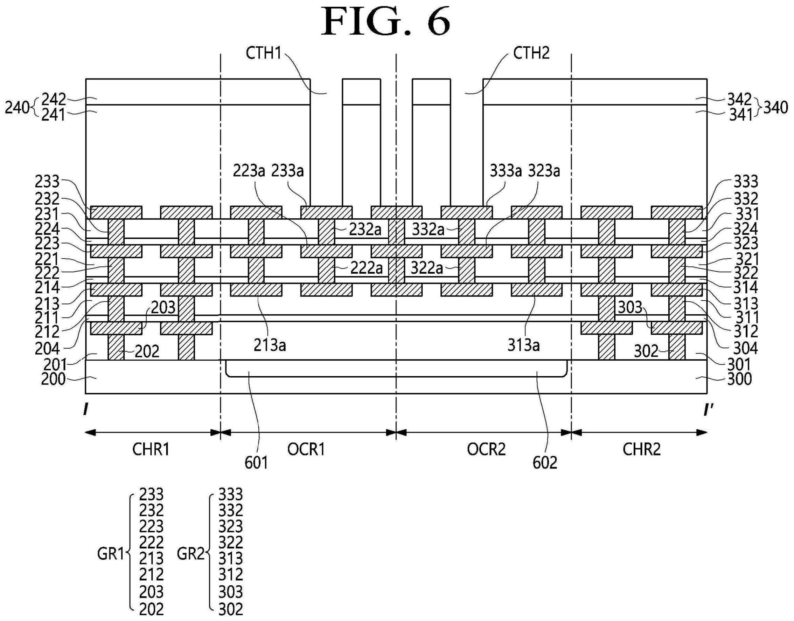

Referring to FIG. 6, the first semiconductor device may include a first isolation layer 601. The first isolation layer 601 may be disposed in the first substrate 200. In an embodiment, the upper surface of the first isolation layer 601 may form substantially the same plane as the upper surface of the first substrate 200. The first isolation layer 601 may be formed using a trench isolation technology such as shallow trench isolation (STI). The first isolation layer 601 may include silicon oxide, silicon nitride, silicon oxynitride, low-k dielectric, high-k dielectric, or a combination thereof.

In an embodiment, as the first isolation layer 601 is disposed in the first substrate 200, cutting of the wafer may be easily performed (for example, unimpeded). Therefore, occurrence of a defect in a semiconductor device due to a cutting defect may be (substantially or to a statistical minimum) prevented.

The second semiconductor device may include a second isolation layer 602. The second isolation layer 602 may include the same material as the first isolation layer 601.

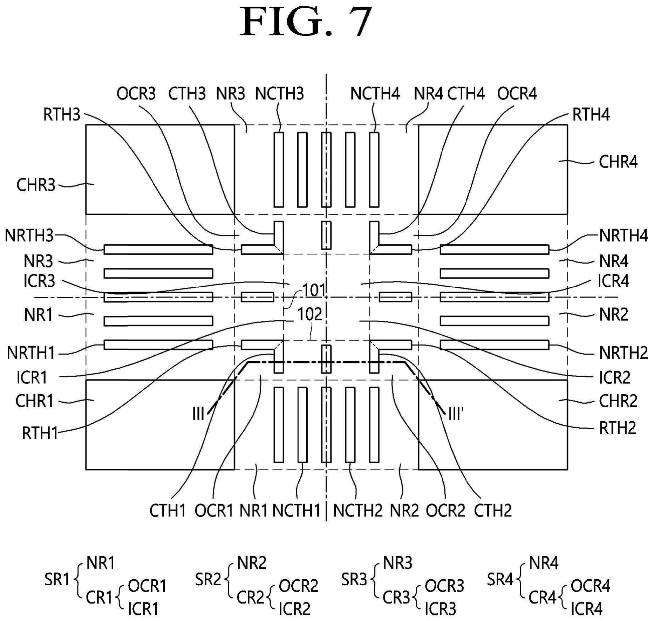

FIG. 7 is a view illustrating a planar structure of a semiconductor device according to embodiments of the present disclosure.

Referring to FIG. 7, a first semiconductor device may include at least one first column trench CTH1 and at least one first row trench RTH1. The first column trench CTH1 and the first row trench RTH1 may be disposed in a first chip adjacent crossing region OCR1. In an embodiment, the first column trench CTH1 and the first row trench RTH1 may be disposed in the first chip adjacent crossing region OCR1 and might not be disposed in a first peripheral crossing region ICR1. The first column trench CTH1 may be disposed in a column direction. The first row trench RTH1 may be disposed in a row direction. The numbers of first row trenches RTH1 and first column trenches CTH1 are not limited to the numbers as illustrated in FIG. 7.

The first row trench RTH1 may be located between the boundary between the first chip adjacent crossing region OCR1 and a first chip adjacent region NR1, and the boundary between the first chip adjacent crossing region OCR1 and a first boundary 101 of the first peripheral crossing region ICR1. In an embodiment, the first row trench RTH1 may be located closer to the first chip adjacent region NR1 in the row direction than the first boundary 101.

The first column trench CTH1 may be located between the boundary between the first chip adjacent crossing region OCR1 and the first chip adjacent region NR1, and the boundary between the first chip adjacent crossing region OCR1 and a second boundary 102 of the first peripheral crossing region ICR1. In an embodiment, the first column trench CTH1 may be located closer to the first chip adjacent region NR1 in the column direction than the second boundary 102.

In an embodiment, the first row trench RTH1 and the first column trench CTH1 might not cross (or intersect, overlap, etc.) each other. In an embodiment, at least one of first row trenches RTH1 and at least one of first column trenches CTH1 may communicate with each other (for example, connect, join, or access each other, etc.). For example, the first row trench RTH1 located closest to a first chip region CHR1 may communicate with the first column trench CTH1 located closest to the first chip region CHR1.

In an embodiment, the first row trench RTH1 may be spaced apart from first chip adjacent row trenches NRTH1. The first column trench CTH1 may be spaced apart from first chip adjacent column trenches NCTH1.

In an embodiment, at least a part of the first row trench RTH1 may overlap the first column trench CTH1.

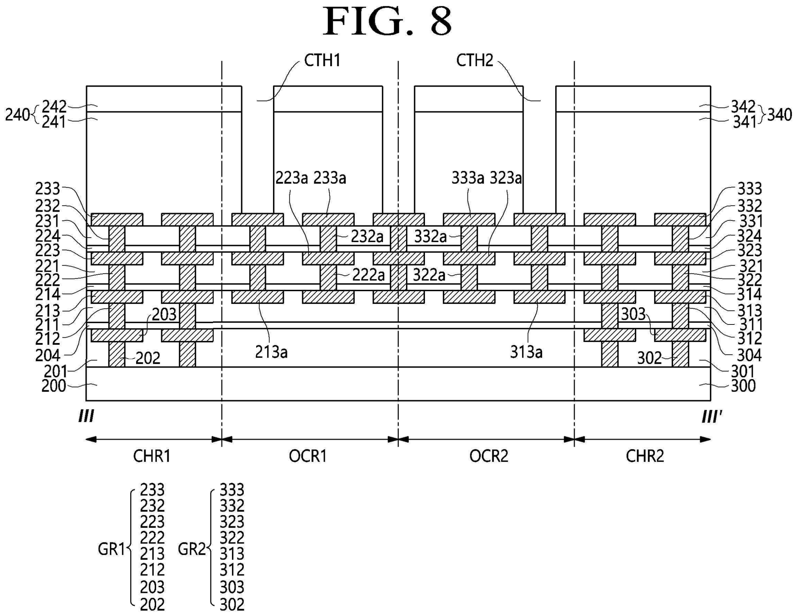

FIG. 8 is a view illustrating a cross-sectional structure of a part indicated by a line III-III' of FIG. 7.

Referring to FIG. 8, the first semiconductor device may include a first substrate 200, a first insulating layer 201, a first guard ring GR1, a first interlayer insulating layer 204, a second insulating layer 211, a second interlayer insulating layer 214, a third insulating layer 221, a third interlayer insulating layer 224, a fourth insulating layer 231, a first passivation layer 240, a first dummy pattern 213a, a first dummy contact 222a, a second dummy pattern 223a, a second dummy contact 232a, a third dummy pattern 233a, and the first column trench CTH1. The first guard ring GR1 may include a first contact 202, a first wiring 203, a second contact 212, a second wiring 213, a third contact 222, a third wiring 223, a fourth contact 232, and a fourth wiring 233. The first passivation layer 240 may include a first lower passivation layer 241 and a first upper passivation layer 242.

The first column trench CTH1 may be located in the first chip adjacent crossing region OCR1. The first column trench CTH1 may be disposed in the first passivation layer 240. In an embodiment, the first column trench CTH1 may overlap the third dummy pattern 233a. In an embodiment, the upper surface of the third dummy pattern 233a may be exposed by the first column trench CTH1. In an embodiment, the side surface of the first passivation layer 240 may be exposed by the first column trench CTH1.

Although the first column trench CTH1 is described with reference to FIG. 8 as an example, the above content may also be applied the same to the first row trench RTH1 described above with reference to FIG. 7. For example, the first row trench RTH1 may be located in the first chip adjacent crossing region OCR1. The first row trench RTH1 may be disposed in the first passivation layer 240. The first dummy pattern 213a, the second dummy pattern 223a, and the third dummy pattern 233a may also be disposed under the first row trench RTH1. In an embodiment, the first row trench RTH1 may overlap the first dummy pattern 213a, the second dummy pattern 223a and the third dummy pattern 233a. In an embodiment, the upper surface of the third dummy pattern 233a may be exposed by the first row trench RTH1.

The second semiconductor device may include a second substrate 300, a fifth insulating layer 301, a second guard ring GR2, a fourth interlayer insulating layer 304, a sixth insulating layer 311, a fifth interlayer insulating layer 314, a seventh insulating layer 321, a sixth interlayer insulating layer 324, an eighth insulating layer 331, a second passivation layer 340, a fourth dummy pattern 313a, a fourth dummy contact 322a, a fifth dummy pattern 323a, a fifth dummy contact 332a, a sixth dummy pattern 333a, and a second column trench CTH2. The second guard ring GR2 may include a fifth contact 302, a fifth wiring 303, a sixth contact 312, a sixth wiring 313, a seventh contact 322, a seventh wiring 323, an eighth contact 332, and an eighth wiring 333. The second passivation layer 340 may include a second lower passivation layer 341 and a second upper passivation layer 342. The components included in the second semiconductor device may be substantially the same as the components, respectively, of the first semiconductor device described above with reference to FIG. 7 and FIG. 8.

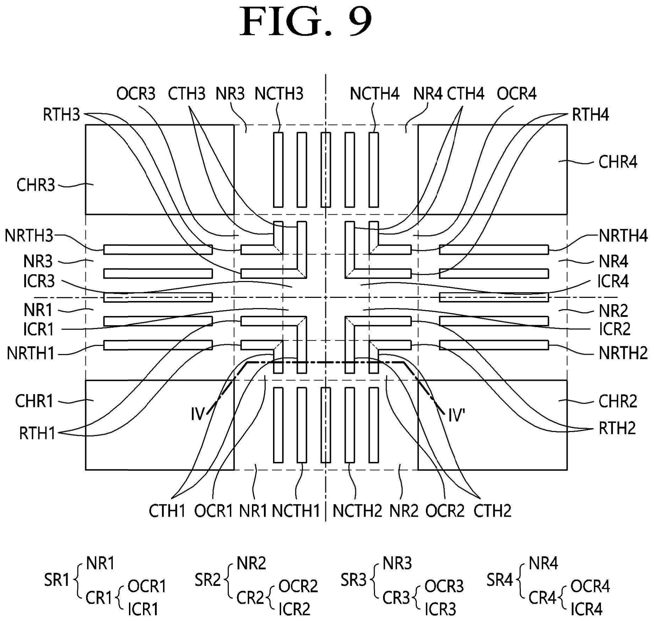

FIG. 9 is a view illustrating a planar structure of a semiconductor device according to embodiments of the present disclosure.

Referring to FIG. 9, a first semiconductor device may include at least one first column trench CTH1 and at least one first row trench RTH1. The first column trench CTH1 and the first row trench RTH1 may be disposed in a first chip adjacent crossing region OCR1. In an embodiment, at least a part of a first column trench CTH1 and at least a part of a first row trench RTH1 may be disposed in a first peripheral crossing region ICR1. The first column trench CTH1 may be disposed in a column direction. The first row trench RTH1 may be disposed in a row direction. At least the part of the first column trench CTH1 may extend from the first chip adjacent crossing region OCR1 to the first peripheral crossing region ICR1. At least the part of the first row trench RTH1 may extend from the first chip adjacent crossing region OCR1 to the first peripheral crossing region ICR1. The numbers of first row trenches RTH1 and first column trenches CTH1 are not limited to the numbers as illustrated in FIG. 9.

In an embodiment, the first row trench RTH1 and the first column trench CTH1 might not cross each other. In an embodiment, each of the first row trenches RTH1 may communicate with a corresponding first column trench CTH1.

In an embodiment, the first row trench RTH1 may be spaced apart from first chip adjacent row trenches NRTH1. The first column trench CTH1 may be spaced apart from first chip adjacent column trenches NCTH1.

In an embodiment, at least a part of the first row trench RTH1 may overlap the first column trench CTH1.

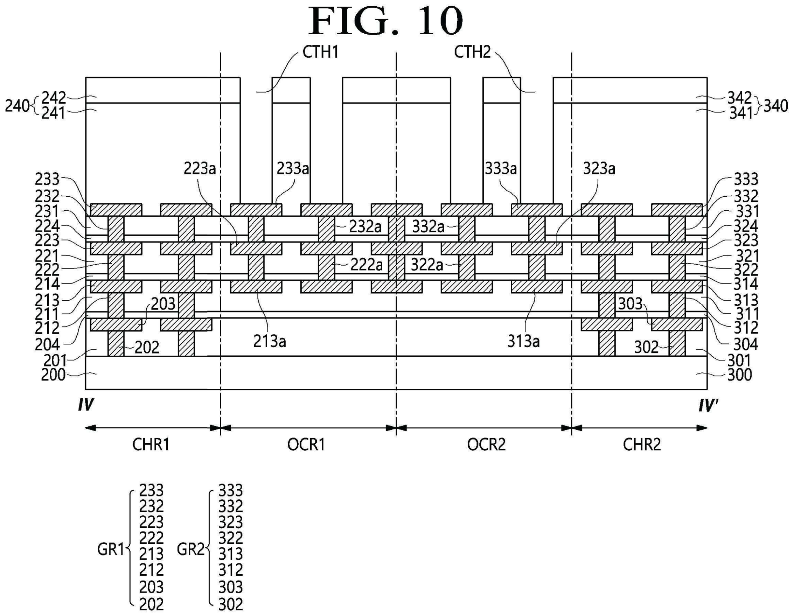

FIG. 10 is a view illustrating a cross-sectional structure of a part indicated by a line IV-IV' of FIG. 9.

Referring to FIG. 10, the first semiconductor device may include a first substrate 200, a first insulating layer 201, a first guard ring GR1, a first interlayer insulating layer 204, a second insulating layer 211, a second interlayer insulating layer 214, a third insulating layer 221, a third interlayer insulating layer 224, a fourth insulating layer 231, a first passivation layer 240, a first dummy pattern 213a, a first dummy contact 222a, a second dummy pattern 223a, a second dummy contact 232a, a third dummy pattern 233a, and the first column trench CTH1. The first guard ring GR1 may include a first contact 202, a first wiring 203, a second contact 212, a second wiring 213, a third contact 222, a third wiring 223, a fourth contact 232, and a fourth wiring 233. The first passivation layer 240 may include a first lower passivation layer 241 and a first upper passivation layer 242.

The first column trench CTH1 may be located in the first chip adjacent crossing region OCR1. The first column trench CTH1 may be disposed in the first passivation layer 240. In an embodiment, the first column trench CTH1 may overlap the first dummy pattern 213a, the second dummy pattern 223a and the third dummy pattern 233a. In an embodiment, the upper surface of the third dummy pattern 233a may be exposed by the first column trench CTH1. In an embodiment, the side surface of the first passivation layer 240 may be exposed by the first column trench CTH1.

Although the first column trench CTH1 is described with reference to FIG. 10 as an example, the above content may also be applied the same to the first row trench RTH1 described above with reference to FIG. 9. For example, the first row trench RTH1 may be located in the first chip adjacent crossing region OCR1. The first row trench RTH1 may be disposed in the first passivation layer 240. The first dummy pattern 213a, the second dummy pattern 223a, and the third dummy pattern 233a may also be disposed under the first row trench RTH1. In an embodiment, the first row trench RTH1 may overlap the first dummy pattern 213a, the second dummy pattern 223a and the third dummy pattern 233a. In an embodiment, the upper surface of the third dummy pattern 233a may be exposed by the first row trench RTH1.

The second semiconductor device may include a second substrate 300, a fifth insulating layer 301, a second guard ring GR2, a fourth interlayer insulating layer 304, a sixth insulating layer 311, a fifth interlayer insulating layer 314, a seventh insulating layer 321, a sixth interlayer insulating layer 324, an eighth insulating layer 331, a second passivation layer 340, a fourth dummy pattern 313a, a fourth dummy contact 322a, a fifth dummy pattern 323a, a fifth dummy contact 332a, a sixth dummy pattern 333a, and a second column trench CTH2. The second guard ring GR2 may include a fifth contact 302, a fifth wiring 303, a sixth contact 312, a sixth wiring 313, a seventh contact 322, a seventh wiring 323, an eighth contact 332, and an eighth wiring 333. The second passivation layer 340 may include a second lower passivation layer 341 and a second upper passivation layer 342. The components included in the second semiconductor device may be substantially the same as the components, respectively, of the first semiconductor device described above with reference to FIG. 9 and FIG. 10.

A conductive layer (not illustrated) may be further disposed in at least a part of each of the first column trench CTH1 and the first row trench RTH1 described above with reference to FIG. 2, FIG. 4 to FIG. 6, FIG. 8, and FIG. 10. The conductive layer may be located on the bottom surface and the side surface of each of the first column trench CTH1 and the first row trench RTH1. In an embodiment, the conductive layer may include the same material as pads for connecting a semiconductor device to the outside. The conductive layer may be made of at least one metal or metal alloy selected from the group consisting of, for example, copper (Cu), aluminum (Al), nickel (Ni), silver (Ag), gold (Au), platinum (Pt), tin (Sn), lead (Pb), titanium (Ti), chromium (Cr), palladium (Pd), indium (In), zinc (Zn) and carbon (C). In an embodiment, the conductive layer may include aluminum (Al).

Referring again to FIG. 1 and FIG. 2, the first row trench RTH1 may be located between the boundary between the first chip adjacent crossing region OCR1 and the first boundary 101 of the first peripheral crossing region ICR1, and the boundary between the first chip adjacent crossing region OCR1 and the first chip adjacent region NR1. The first column trench CTH1 may be located between the boundary between the first chip adjacent crossing region OCR1 and the second boundary 102 of the first peripheral crossing region ICR1, and the boundary between the first chip adjacent crossing region OCR1 and the first chip adjacent region NR1. The first row trench RTH1 and the first column trench CTH1 might not cross each other. The first row trench RTH1 and the first column trench CTH1 might not be disposed in the first peripheral crossing region ICR1.

According to the embodiments of the present disclosure, as the first column trench CTH1 and the first row trench RTH1 are disposed in the first chip adjacent crossing region OCR1, a cutting defect occurring during a cutting process may be minimized. This may be described in detail as follows.

The first row trench RTH1 is disposed in a region where the boundary line between the first semiconductor device and the third semiconductor device passes, in a direction in which the boundary line passes. Therefore, the first row trench RTH1 may perform a function of guiding cutting when performing a process of cutting the two semiconductor devices after forming the first semiconductor device and the third semiconductor device on the wafer. In addition, the first row trench RTH1 is not disposed in a region where the boundary line between the first semiconductor device and the second semiconductor device passes. Therefore, when performing a process of cutting the two semiconductor devices after forming the first semiconductor device and the second semiconductor device, the straightness of cutting may increase. For example, although the first row trench RTH1 is perpendicular to a line of cutting of the first semiconductor device and the second semiconductor device, the first row trench RTH1 may not overlap the cutting line of the two semiconductor devices after forming the first semiconductor device and the second semiconductor device, and therefore allow an even cutting process.

Similarly, the first column trench CTH1 is disposed in a region where the boundary line between the first semiconductor device and the second semiconductor device passes, in a direction in which the boundary line passes. Therefore, the first column trench CTH1 may perform a function of guiding cutting when performing a process of cutting the two semiconductor devices after forming the first semiconductor device and the second semiconductor device on the wafer. In addition, the first column trench CTH1 is not disposed in a region where the boundary line between the first semiconductor device and the third semiconductor device passes. Therefore, when performing a process of cutting the two semiconductor devices after forming the first semiconductor device and the third semiconductor device, the straightness of cutting may increase.

According to the embodiments of the present disclosure, because each of the first row trench RTH1 and the first column trench CTH1 may play the role of guiding cutting and increasing the straightness of cutting, a cutting defect occurring during a cutting process may be minimized.

While the detailed embodiments of the present disclosure are disclosed in the present disclosure, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope.

## Claims

1. A semiconductor device comprising:
a substrate including a chip region and a scribe lane region, the scribe lane region including a chip adjacent region, a chip adjacent crossing region that abuts the chip adjacent region, and a peripheral crossing region that abuts the chip adjacent crossing region and is spaced apart from the chip adjacent region;
a passivation layer on the substrate;
row trenches disposed between a first boundary between the chip adjacent crossing region and the peripheral crossing region, and a boundary between the chip adjacent crossing region and the chip adjacent region, in a direction that crosses the first boundary, and disposed in the passivation layer; and
column trenches disposed between a second boundary between the chip adjacent crossing region and the peripheral crossing region, and a boundary between the chip adjacent crossing region and the chip adjacent region, in a direction that crosses the second boundary, and disposed in the passivation layer.

2. The semiconductor device according to claim 1, wherein each of the row trenches and each of the column trenches do not cross each other.

3. The semiconductor device according to claim 1, further comprising:
chip adjacent row trenches disposed in the direction that crosses the first boundary, in the chip adjacent region, and located in the passivation layer; and
chip adjacent column trenches disposed in the direction that crosses the second boundary, in the chip adjacent region, and located in the passivation layer,
wherein the row trenches are spaced apart from the chip adjacent row trenches, and the column trenches are spaced apart from the chip adjacent column trenches.

4. The semiconductor device according to claim 1, further comprising
dummy patterns located in the chip adjacent crossing region, and overlapping the row trenches and the column trenches, respectively.

5. The semiconductor device according to claim 4, wherein the bottom surface of each of the row trenches and the column trenches is spaced apart from the upper surface of each of the dummy patterns.

6. The semiconductor device according to claim 4, wherein the upper surfaces of the dummy patterns are exposed by the row trenches and the column trenches.

7. The semiconductor device according to claim 1, wherein a row trench located closest to the chip region among the row trenches communicates with a column trench located closest to the chip region among the column trenches.

8. The semiconductor device according to claim 1, wherein each of the row trenches communicates with a corresponding one of the column trenches.

9. The semiconductor device according to claim 1, further comprising
an isolation layer disposed in the substrate,
wherein the isolation layer is disposed in the chip adjacent crossing region and the peripheral crossing region.

10. The semiconductor device according to claim 1, wherein the passivation layer includes high density plasma oxide, nitride, or a combination thereof.

11. A semiconductor device comprising:
a substrate including a chip region and a scribe lane region, the scribe lane region including a chip adjacent region, a chip adjacent crossing region that abuts the chip adjacent region, and a peripheral crossing region that abuts the chip adjacent crossing region and is spaced apart from the chip adjacent region;
row trenches disposed in the chip adjacent crossing region in a direction that crosses a first boundary; and
column trenches disposed in the chip adjacent crossing region in a direction that crosses a second boundary crossing the first boundary,
wherein each of the row trenches and each of the column trenches do not cross each other.

12. The semiconductor device according to claim 11, further comprising
a passivation layer on the substrate,
wherein the row trenches and the column trenches are disposed in the passivation layer.

13. The semiconductor device according to claim 12, wherein the row trenches are disposed between the first boundary between the chip adjacent crossing region and the peripheral crossing region, and a boundary between the chip adjacent crossing region and the chip adjacent region, and the column trenches are disposed between the second boundary between the chip adjacent crossing region and the peripheral crossing region, and a boundary between the chip adjacent crossing region and the chip adjacent region.

14. The semiconductor device according to claim 12, further comprising:
chip adjacent row trenches disposed in the direction that crosses the first boundary, in the chip adjacent region, and located in the passivation layer; and
chip adjacent column trenches disposed in the direction that crosses the second boundary, in the chip adjacent region, and located in the passivation layer,
wherein the row trenches are spaced apart from the chip adjacent row trenches, and the column trenches are spaced apart from the chip adjacent column trenches.

15. The semiconductor device according to claim 11, further comprising
dummy patterns located in the chip adjacent crossing region, and overlapping the row trenches and the column trenches, respectively.

16. The semiconductor device according to claim 11, wherein a row trench located closest to the chip region among the row trenches communicates with a column trench located closest to the chip region among the column trenches.

17. The semiconductor device according to claim 11, wherein each of the row trenches communicates with a corresponding one of the column trenches.

18. The semiconductor device according to claim 11, further comprising
an isolation layer disposed in the substrate,
wherein the isolation layer is disposed in the chip adjacent crossing region and the peripheral crossing region.

19. A semiconductor device comprising:
a substrate including a chip region and a scribe lane region, the scribe lane region including a chip adjacent region, a chip adjacent crossing region that abuts the chip adjacent region, and a peripheral crossing region that abuts the chip adjacent crossing region and is spaced apart from the chip adjacent region;
a passivation layer on the substrate;
row trenches disposed in the passivation layer outside of the peripheral crossing region between a first boundary that marks an outer edge of the peripheral crossing region and a second boundary that marks an outer edge of the chip region, wherein at least one of the row trenches is disposed in the chip adjacent crossing region; and
column trenches disposed in the passivation layer outside of the peripheral crossing region between a third boundary, perpendicular to the first boundary, that marks an outer edge of the peripheral crossing region and a fourth boundary, perpendicular to the second boundary, that marks an outer edge of the chip region, wherein at least one of the column trenches is disposed in the chip adjacent crossing region.

20. The semiconductor device according to claim 19, wherein the column trenches include chip adjacent column trenches disposed in the chip adjacent region and chip adjacent crossing trenches disposed in the chip adjacent crossing region.
